# EUROPEAN PATENT APPLICATION

(11) **EP 2 124 075 A1**
(43) Date of publication of application: **25.11.2009**
(21) Application number: 09159369.9
(22) Date of filing: 05.05.2009
(51) Int. Cl.: G02B 5/18

(54) **Optical grating and method of producing same, and linear encoder and optical microscope equipped with optical grating**

(30) Priority: 22.05.2008 JP 2008134388
(71) Applicant: Mitutoyo Corporation, Kawasaki-shi, Kanagawa-ken 213-0012 (JP)
(72) Inventor: Kojima, Kenichi, Kawasaki-shi Kanagawa 213-8533 (JP)
(74) Representative: Skone James, Robert Edmund

(57) **Abstract**

A method of producing an optical grating includes: forming a first film 12 comprising a substance having an aromatic ring that becomes a free radical and can undergo desorption on exposure to light on at least one surface of a glass substrate 10 (S100), exposing the first film 12 in a grating pattern using light of a wavelength that is capable of desorbing the aromatic ring in the form of a free radical (S102), washing the surface of the exposed first film 12 with water, thereby exposing hydroxyl groups 16 within the light-exposed portions (S104), forming a second film 18 by applying a substance having an amino group capable of bonding with the hydroxyl groups exposed in a grating pattern on the surface of the first film 12 by the water washing, thereby reacting the amino groups with the hydroxyl groups (S106), providing catalyst nuclei to the second film 18 to form a catalyst nuclei layer (S108), and forming a light reflection layer by electroless plating to the catalyst nuclei (S110).

## Description

### Technical Field

The present invention relates to an optical grating that can be used in a photoelectric encoder, a method of producing the optical grating, and a linear encoder and an optical microscope equipped with the optical grating.

### Related Art

Scales used in photoelectric encoders can be broadly classified into amplitude grating scales and phase grating scales. In either type of scale, the accuracy of the scale is determined by the precision of the grating pattern formed on the substrate.

Conventionally, an electromagnetic induction type displacement detection scale comprises a grating pattern composed of a conductive metal with a high degree of conductivity such as copper formed on an insulating glass epoxy substrate. However, because glass epoxy substrates have poor surface precision and a high coefficient of expansion, the grating pattern tends to be prone to detachment from the substrate, and producing a high-precision scale with a resolution of 10 µm or less has proven difficult.

JP 2003-21538 A proposes the use of a glass substrate instead of the glass epoxy substrate mentioned above, and a scale is produced by forming an electroless copper plating layer on the glass substrate by electroless plating, forming a resist pattern that matches the shape of the desired grating pattern on top of the electroless copper plating layer, and then etching the electroless copper plating layer through this resist pattern.

In the above production of an optical grating by lithography using a resist, a heating step (for example, prebake) is necessary. However, there is a possibility that expansion of the glass substrate caused by the heat applied during this heating step may have an adverse effect on the scale precision.

### SUMMARY

The present invention has been developed in light of the above problems, and provides an optical grating having stable scale precision in which the optical element can be produced at room temperature or low temperature without heating the substrate, meaning the effect of heat on the substrate is significantly reduced, as well as a method of producing such an optical grating, a linear encoder, and an optical microscope.

The optical element and method of production therefor, the linear encoder, and the optical microscope according to the present invention have the features described below.
(1) An optical grating used in a photoelectric encoder that detects the reflection of light in a predetermined wavelength band, the optical grating comprising a substrate, a first film formed on at least one surface of the substrate and comprising a substance having an aromatic ring that becomes a free radical and can undergo desorption on exposure to light, a second film that is formed in a grating shape on top of the first film and has amino groups exposed at the film surface, a catalyst nuclei layer comprising catalyst nuclei capable of bonding with the amino groups of the second film, and a light reflection layer formed on top of the catalyst nuclei layer.
   The first film, the second film, the catalyst nuclei layer, and the light reflection layer are formed by chemical bonding reactions that do not require a heating step, leading to the formation of a light reflection layer that functions as a grating pattern on top of the substrate. Accordingly, the effects caused by heating of the substrate are reduced, and the resulting optical grating exhibits stable scale precision.
(2) The optical grating disclosed in (1) above, wherein the substrate is a glass substrate, and the substance that constitutes the first film, having an aromatic ring that becomes a free radical and can undergo desorption on exposure to light, is an aromatic organosilane.
   By treating the glass surface with an aromatic organosilane, the hydroxyl groups at the surface of the glass substrate and the organosilane molecules undergo a chemical reaction, and the mutual interaction between organosilane molecules forms a three dimensional network structure, resulting in the formation of a so-called self-assembled film. As a result, the first film is bonded powerfully to the glass substrate without requiring a heating step.
(3) The optical grating disclosed in (1) or (2) above, wherein the catalyst nuclei are composed of lead, and the light reflection layer comprises nickel.
   Chemical bonding between the amino groups exposed at the surface of the second film and the lead of the catalyst nuclei enables the catalyst nuclei layer to be formed precisely in a grating-shaped grating pattern, and by using the catalyst nuclei layer composed of lead, electroless plating or the like can then be used to form a light reflection layer comprising nickel.
(4) A linear encoder that uses the optical grating disclosed in any one of (1) to (3) above as a scale.
   Because the optical grating has a stable scale precision, the precision of a linear encoder that uses the optical grating as a scale can be improved. Moreover, because the scale precision can be favorably maintained even at the nanometer level, a linear encoder with nano-order resolution can be obtained.
(5) An optical microscope comprising the linear encoder disclosed in (4) above.
   By employing a linear encoder that exhibits superior precision and nano-order resolution, an optical microscope having superior nano-order precision can be provided.
(6) A method of producing an optical grating used in a photoelectric encoder that detects the reflection of light in a predetermined wavelength band, the method comprising: forming a first film comprising a substance having an aromatic ring that becomes a free radical and can undergo desorption on exposure to light on at least one surface of a substrate, exposing the first film in a grating pattern using light of a wavelength that is capable of desorbing the aromatic ring in the form of a free radical from the substance having the aromatic ring, washing the surface of the exposed first film with water, forming a second film by applying a substance having an amino group capable of bonding with the hydroxyl groups exposed in a grating pattern on the surface of the first film by the water washing, thereby reacting the amino groups with the hydroxyl groups, providing catalyst nuclei that are capable of bonding with the amino groups exposed in a grating pattern on the surface of the second film, and forming a light reflection layer by electroless plating to the catalyst nuclei.
   The first film, the second film, the catalyst nuclei layer, and the light reflection layer are formed by chemical bonding reactions that do not require a heating step, leading to the formation of a light reflection layer that functions as a grating pattern on top of the substrate. Accordingly, the effects caused by heating of the substrate are reduced, and an optical grating can be produced that exhibits stable scale precision.
(7) The method of producing an optical grating disclosed in (6) above, wherein the substrate is a glass substrate, the substance having an aromatic ring used in forming the first film is an aromatic organosilane, the exposure wavelength used during exposure is ultraviolet radiation, and the substance having an amino group used in forming the second film is a silicate ester amine.
   By treating the glass surface with an aromatic organosilane, the hydroxyl groups at the surface of the glass substrate and the organosilane molecules undergo a chemical reaction, and the mutual interaction between organosilane molecules forms a three dimensional network structure, resulting in the formation of a so-called self-assembled film. As a result, the first film is bonded powerfully to the glass substrate without requiring a heating step. Further, by using ultraviolet radiation as the exposure wavelength, the aromatic rings within the exposed portions absorb the ultraviolet radiation, are excited, and form free radicals that then undergo desorption, leaving other residual radicals within the exposed portions. The subsequent washing with water appends hydroxyl groups to these other residual radicals, and by then conducting a dehydration condensation reaction between these hydroxyl groups and a silicate ester amine, a three dimensional network structure bonded strongly to the first film by silicate chains is formed, while amino groups are exposed in a grating pattern on the surface of the second film. Accordingly, the catalyst nuclei bond only to the amino groups exposed at the surface of the second film, and because the electroless plating layer is then formed only to the catalyst nuclei layer composed of these catalyst nuclei, an optical grating can be produced that has a high scale precision, and for example, exhibits high precision even at the nanometer level.
(8) The method of producing an optical grating disclosed in (6) or (7) above, wherein the catalyst nuclei are composed of lead, and the light reflection layer comprises nickel.
   Chemical bonding between the amino groups exposed at the surface of the second film and the lead of the catalyst nuclei enables the catalyst nuclei layer to be formed precisely in a grating-shaped grating pattern, and by using the catalyst nuclei layer composed of lead, electroless plating or the like can then be used to form a light reflection layer comprising nickel. Accordingly, the effects caused by heating of the substrate are reduced, and an optical grating that exhibits superior scale precision can be produced.

According to the present invention, an optical grating can be provided that exhibits superior grating pattern precision even at the nanometer level. Furthermore, a high-precision linear encoder and optical microscope that use the optical grating can also be provided.

### BRIEF DESCRIPTION OF THE DRAWINGS

Exemplary embodiment(s) of an aspect of the present invention will be described in detail based on the following figure, wherein:
FIG. 1 is a diagram describing one example of a method of producing an optical grating according to an embodiment of the present invention, describing a first film formation step (step S100) through to a second film formation step (step S106);
FIG. 2 is a diagram describing one example of a method of producing an optical grating according to an embodiment of the present invention, describing a catalyst nuclei provision step (step S108) through to a protective layer formation step (step S112);
FIG. 3 is a diagram describing one example of an exposure step (step S102) in a method of producing an optical grating according to an embodiment of the present invention;
FIG. 4 is a diagram describing one example of a water washing step (step S104) in a method of producing an optical grating according to an embodiment of the present invention;
FIG. 5 is a diagram describing one example of a second film formation step (step S106) in a method of producing an optical grating according to an embodiment of the present invention; and
FIG. 6 is a diagram describing one example of a catalyst nuclei provision step (step S108) in a method of producing an optical grating according to an embodiment of the present invention.

### DETAILED DESCRIPTION

### [Optical Grating and Method of Producing same]

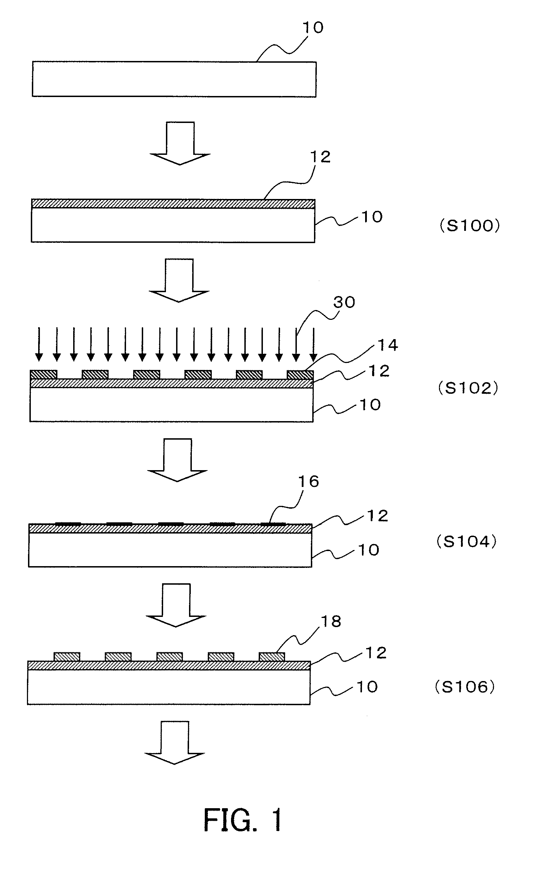

A method of producing an optical grating according to an embodiment of the present invention is described below with reference to FIG. 1 to FIG. 6.

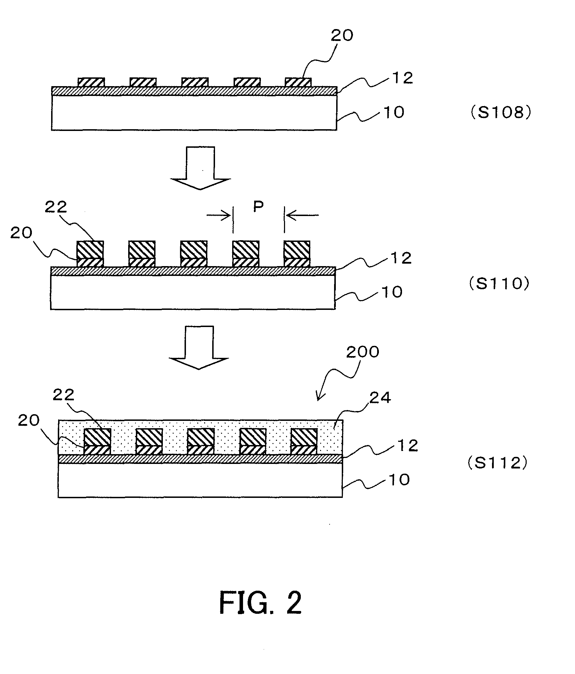

As shown in FIG. 1 and FIG. 2, the method of producing an optical grating includes a first film formation step (step S100) of forming a first film 12, comprising a substance having an aromatic ring that becomes a free radical and can undergo desorption on exposure to light, on at least one surface of a glass substrate 10, an exposure step (step S102) of exposing the first film 12 in a grating pattern using light of a wavelength that is capable of desorbing the aromatic ring in the form of a free radical from the substance having the aromatic ring, a water washing step (step S104) of washing the surface of the exposed first film 12 with water, thereby exposing hydroxyl groups 16 within the light-exposed portions, a second film formation step (step S106) of forming a second film 18 by applying a substance having an amino group capable of bonding with the hydroxyl groups exposed in a grating pattern on the surface of the first film 12, thereby reacting the amino groups with the hydroxyl groups, a catalyst nuclei provision step (step S108) of providing catalyst nuclei that are capable of bonding with the amino groups exposed in a grating pattern on the surface of the second film 18, thereby forming a catalyst nuclei layer 20, and a light reflection layer formation step (step S110) of forming a light reflection layer 22 by electroless plating to the catalyst nuclei. Moreover, in consideration of preventing degradation, a protective layer formation step (step S112) of forming a protective layer 24 on the surfaces of the first film 12, the catalyst nuclei layer 20 and the light reflection layer 22 may also be provided.

A more detailed description of each of the steps of the above production method, and the materials used in each of those steps, is presented below with reference to FIG. 1 through FIG. 6.

First, for reasons of transparency, a glass substrate 10 is used as the substrate in the present embodiment. Furthermore, in order to reduce the effects of thermal expansion, a low expansion glass substrate is preferred as the glass substrate 10.

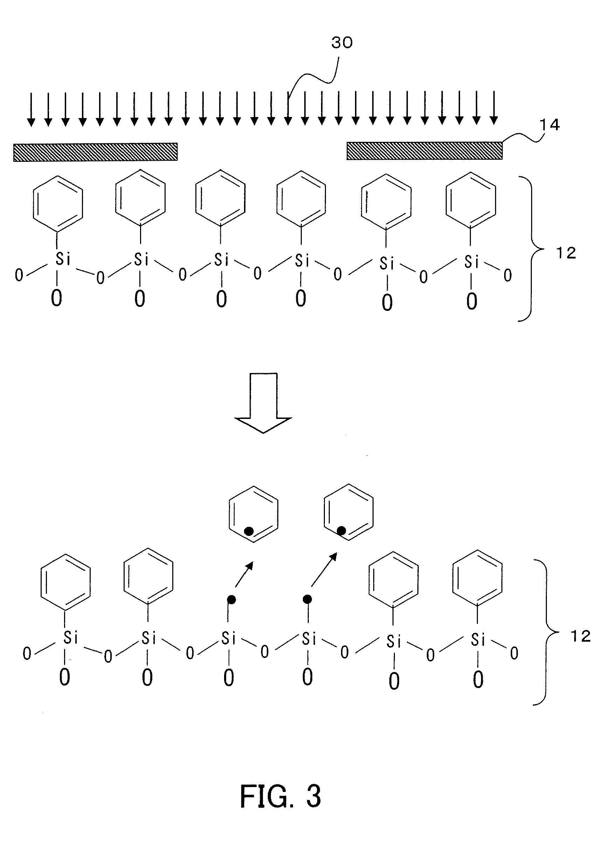

In the first film formation step (step S100), the substance having an aromatic ring that becomes a free radical and can undergo desorption on exposure to light is applied at room temperature (for example, 25°C) to form the first film 12. Examples of substances that can be used as the substance having an aromatic ring that becomes a free radical and can undergo desorption on exposure to light include aromatic organosilanes, and this aromatic organosilane may be selected from the group consisting of monocyclic aromatic organosilanes and polycyclic aromatic organosilanes. One example of a monocyclic aromatic organosilane that can be used is phenyltrichlorosilane. By using phenyltrichlorosilane as the aromatic organosilane, applying the phenyltrichlorosilane to the glass substrate 10, and then leaving the applied layer to stand at room temperature (for example, 25°C) for a predetermined period, a self-assembly process proceeds as a result of the chemical reaction between the hydroxyl groups at the surface of the glass substrate and the phenyltrichlorosilane, leading to the formation of a first film 12 comprising [Ph-SiO3]n (hereafter also referred to as the "first self-assembled film"), as shown in FIG. 3.

Next, in the exposure step (step S102), portions of the first film 12 are exposed in a grating pattern using light of a wavelength that is capable of desorbing the aromatic rings in the form of free radicals. In those cases where the first film 12 comprises a monocyclic aromatic organosilane, exposure is conducted using an ultraviolet light wavelength that can be absorbed by phenyl groups, such as a light having a wavelength of 193 nm or 248 nm. As shown in FIG. 3, this exposure causes excitation of the phenyl groups, which then desorb as free radicals, leaving residual radicals on those portions of the first film 12 from where the phenyl groups have desorbed. On the other hand, in those cases where a polycyclic aromatic organosilane is used as the aromatic organosilane, exposure is preferably conducted using light having a wavelength that is equal to the maximum absorption wavelength for the polycyclic group such as a naphthyl group or anthracenyl group. The width of the exposure beam, for example in the case of a nano-order grating pattern, is typically within a range from 10 to 30 nm, and is preferably 20 nm.

Examples of the method used for exposing portions of the first film 12 to form a grating pattern include methods that use a photomask 14 as shown in FIG. 1 and FIG. 3, and methods that use an interference pattern.

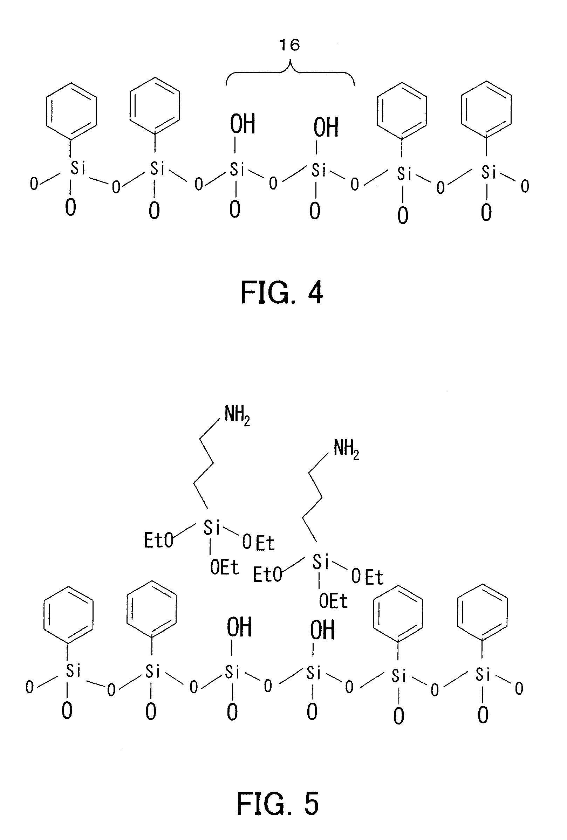

Next, in the water washing step (step S104), the exposed surface of the first film 12 is washed with water, thus appending hydroxyl groups (-OH groups) 16 to the residual radical portions that were formed in a grating pattern on the first film 12 by the exposure step, as shown in FIG. 1 and FIG. 4.

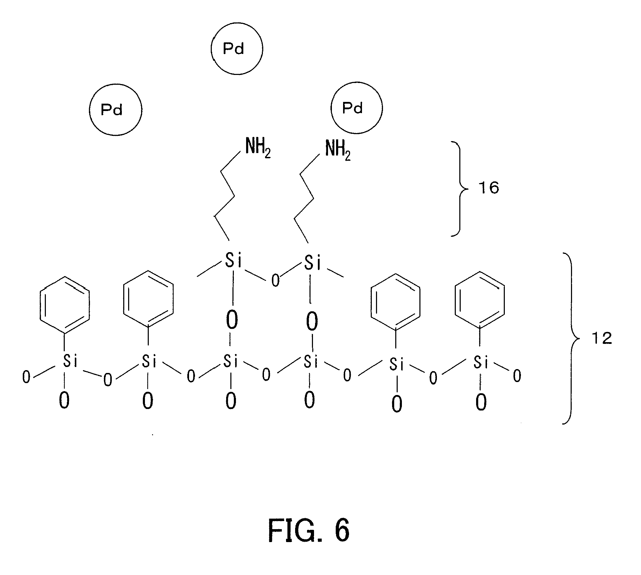

Subsequently, in the second film formation step (step S106), a substance having an amino group capable of bonding with the hydroxyl groups exposed in a grating pattern on the surface of the first film 12 by the water washing is applied, and the amino groups are reacted with the hydroxyl groups, thereby forming the second film 18. Any aliphatic primary amine or secondary amine capable of reacting with the hydroxyl groups may be used as the substance having an amino group. The number of aliphatic carbon atoms within the amine is preferably from 2 to 6, and a primary amine is preferred in terms of reactivity. For example, silicate ester amines can be used favorably. An example of a silicate ester amine that may be used is 3-aminopropyltriethoxysilane ((CH3CH2O)3-Si-CH2CH2CH2NH2). For example, as shown in FIG. 5 and FIG. 6, when 3-aminopropyltriethoxysilane undergoes a dehydration condensation reaction with the hydroxyl groups exposed in a grating pattern on the surface of the first film 12, the second film 18 is formed with amino groups exposed in the same pattern as the grating pattern of the first film 12.

In the subsequent catalyst nuclei provision step (step S108), as shown in FIG. 2 and FIG. 6, catalyst nuclei that are capable of bonding to the amino groups exposed in a grating pattern at the surface of the second film 18 are provided by conducting a wet treatment with a catalyst liquid. In consideration of the subsequent steps, metallic lead (Pd) is preferred as the catalyst nuclei.

Next, in the light reflection layer formation step (step S110), the light reflection layer 22 is formed on top of the catalyst nuclei by electroless plating. In one example of this step, the substrate having the catalyst nuclei layer 20 formed thereon is dipped in a solution prepared by diluting a reducing agent and a plating solution comprising nickel metal ions with pure water, thereby performing electroless nickel plating and forming the light reflection layer 22. The light reflection layer 22 has a thickness of λ/4 relative to the wavelength λ used for the optical grating, so that for example, if the wavelength used for the optical element is 640 nm, then the thickness of the light reflection layer 22 is 160 nm. For example, by conducting the electroless nickel plating by dipping for approximately one minute in a plating bath having a pH of 5.6 to 6.2 and a temperature of 88°C to 92°C, a light reflection layer comprising nickel is formed with the required thickness.

Because the light reflection layer 22 is formed by electroless plating onto only the catalyst nuclei layer 20 formed from the catalyst nuclei, an optical grating can be produced that has superior scale precision, and even if the pitch P is at the nanometer level, a high precision optical grating can be produced.

In order to prevent degradation, in the protective layer formation step (step S112), a protective layer 24 is formed on the surfaces of the first film 12, the catalyst nuclei layer 20, and the light reflection layer 22. Examples of the protective layer 24 include a protective layer comprising alumina as the main component formed using an ALD method, or a protective layer formed from a fluororesin.

As shown in FIG. 2, an optical grating 200 of the present embodiment formed using the production method described above comprises the glass substrate 10, the first film 12 formed on at least one surface of the glass substrate 10 and comprising a substance having an aromatic ring that becomes a free radical and can undergo desorption on exposure to light, the second film 18 that is formed in a grating shape on top of the first film 12 and has amino groups exposed at the film surface, the catalyst nuclei layer 20 comprising catalyst nuclei capable of bonding with the amino groups of the second film 18, and the light reflection layer 22 formed on top of the catalyst nuclei layer 20, and if required, may also include the protective layer 24 formed on the surfaces of the first film 12, the catalyst nuclei layer 20, and the light reflection layer 22. The glass substrate 10, the first film 12, the second film 18, and the catalyst nuclei layer 20 are as described above, and therefore no further description of these components is provided here.

### [Linear Encoder and Optical Microscope]

A linear encoder of an embodiment of the present invention uses the optical grating described above as a scale. Furthermore, an optical microscope of an embodiment of the present invention is equipped with a linear encoder that uses the optical grating described above as a scale.

In conventional methods of producing optical gratings by a lithography process that uses a resist, because a heating step is required, the dimensions of the optical grating tend to change gradually over long periods (of several months to several years). In contrast, the method of producing an optical grating according to the present invention does not include a heating step, and therefore the dimensions of the optical grating do not change, even over long periods, which represents an extremely favorable feature that is not provided by conventional optical gratings. Accordingly, a linear encoder having an optical grating prepared using this production method remains stable, with absolutely no variation in dimensions, even over long periods (of several months to several years), and using such a linear encoder in precision measuring equipment such as optical microscopes or three dimensional measuring devices yields the superior effect of enabling highly precise measurements to be conducted with favorable reliability over long periods.

### EXAMPLES

### Example 1.

Phenyltrichlorosilane was applied to a low expansion glass substrate 10 having a linear coefficient of expansion of 0.02 × 10-6 /K, and was then left to stand at 25°C for a predetermined period, thus forming a first film 12 such as that shown in FIG. 1 having a dried film thickness of several nm or less. Subsequently, using an interference pattern, the first film 12 was exposed for several seconds using ultraviolet radiation having a wavelength of 248 nm, thus forming a grating pattern having a width of 20 µm and a grating pattern pitch of 40 µm. The exposed surface of the first film 12 was then washed for several minutes with pure water, and 3-aminopropyltriethoxysilane ((CH3CH2O)3-Si-CH2CH2CH2NH2) was then applied, and a dehydration condensation reaction was conducted to form a second film 18. Using a wet treatment with a catalyst liquid, metallic lead was then layered onto only the second film 18, thus forming a catalyst nuclei layer 20. Subsequently, the substrate was dipped for approximately one minute in a 90°C plating bath having a pH within a range from 5.5 to 6.2, thereby forming a light reflection layer 22 comprising nickel with a thickness of 160 nm.

The foregoing description of the exemplary embodiments of the present invention has been provided for the purposes of illustration and description. It is not intended to be exhaustive or to limit the invention to the precise forms disclosed. Obviously, many modifications and variations will be apparent to practitioners skilled in the art. The exemplary embodiments were chosen and described in order to best explain the principles of the invention and its practical applications, thereby enabling others skilled in the art to understand the invention for various embodiments and with the various modifications as are suited to the particular use contemplated. It is intended that the scope of the invention be defined by the following claims and their equivalents.

## Claims

1. An optical grating used in a photoelectric encoder that detects reflection of light in a predetermined wavelength band, the optical grating comprising:
a substrate,
a first film formed on at least one surface of the substrate and comprising a substance having an aromatic ring that becomes a free radical and can undergo desorption on exposure to light,
a second film that is formed in a grating shape on top of the first film and has amino groups exposed at a surface thereof,
a catalyst nuclei layer comprising catalyst nuclei capable of bonding with the amino groups of the second film, and
a light reflection layer formed on top of the catalyst nuclei layer.

2. The optical grating according to Claim 1, wherein
the substrate is a glass substrate, and
the substance that constitutes the first film, having an aromatic ring that becomes a free radical and can undergo desorption on exposure to light, is an aromatic organosilane.

3. The optical grating according to Claim 1 or Claim 2, wherein
the catalyst nuclei are composed of lead, and
the light reflection layer comprises nickel.

4. A linear encoder that uses the optical grating according to any one of Claims 1 to 3 as a scale.

5. A method of producing an optical grating used in a photoelectric encoder that detects reflection of light in a predetermined wavelength band, the method comprising:
forming a first film, comprising a substance having an aromatic ring that becomes a free radical and can undergo desorption on exposure to light, on at least one surface of a substrate,
exposing the first film in a grating pattern using light of a wavelength that is capable of desorbing the aromatic ring in the form of a free radical from the substance having the aromatic ring,
washing a surface of the exposed first film with water,
forming a second film by applying a substance having an amino group capable of bonding with hydroxyl groups exposed in a grating pattern on the surface of the first film by water washing, thereby reacting the amino groups with the hydroxyl groups,
providing catalyst nuclei that are capable of bonding with the amino groups exposed in a grating pattern on a surface of the second film, and
forming a light reflection layer by electroless plating to the catalyst nuclei.

6. The method of producing an optical grating according to Claim 5, wherein the substrate is a glass substrate,
the substance having an aromatic ring used in forming the first film is an aromatic organosilane,
an exposure wavelength used during exposure is ultraviolet radiation, and
the substance having an amino group used in forming the second film is a silicate ester amine.

7. The method of producing an optical grating according to Claim 5 or Claim 6, wherein
the catalyst nuclei are composed of lead, and
the light reflection layer comprises nickel.
